Europäisches Patentamt

European Patent Office

Office européen des brevets

(11) Veröffentlichungsnummer : **0 017 730**
**B1**

(12) **EUROPÄISCHE PATENTSCHRIFT**

(45) Veröffentlichungstag der Patentschrift :
16.02.83

(51) Int. Cl.³ : **H 03 K  5/02**

(21) Anmeldenummer : **80100857.4**

(22) Anmeldetag : **21.02.80**

(54) **Gegengekoppelter Differentialverstärker.**

(30) Priorität : **12.04.79 US 29590**

(43) Veröffentlichungstag der Anmeldung :
**29.10.80 Patentblatt 80/22**

(45) Bekanntmachung des Hinweises auf die Patenterteilung : **16.02.83 Patentblatt 83/07**

(84) Benannte Vertragsstaaten :
**DE FR GB NL SE**

(56) Entgegenhaltungen :
**DE A 2 226 471**

**IBM TECHNICAL DISCLOSURE BULLETIN, Band
16, Nr. 5, Oktober 1973, Seiten 1600-16001 New
York, U.S.A. P.R. EPLEY et al. : « Schmitt trigger
circuit »
IBM TECHNICAL DISCLOSURE BULLETIN, Band
19, Nr. 1, Juni 1976, Seite 137 New York, U.S.A. P.
DEBORD et al. : «High-speed comparator »
IBM TECHNICAL DISCLOSURE BULLETIN, Band
10, Nr. 5, Oktober 1967, Seiten 672-673 New York,
U.S.A. P.D. BELLAMY et al. : « Nonsaturating, low
source impedance, complementary driver »
IBM TECHNICAL DISCLOSURE BULLETIN, Band
12, Nr. 12, Mai 1970, Seite 2123 New York, U.S.A.
N.M. DONOFRIO et al. : « Differential shunt feed-
back sense amplifier »**

(73) Patentinhaber : **International Business Machines Corporation
Armonk, N.Y. 10504 (US)**

(72) Erfinder : **Furman, Anatol
Main Street P.O. Box 136
Fairfax, VT 05454 (US)**

(74) Vertreter : **Böhmer, Hans Erich, Dipl.-Ing.
Schönaicher Strasse 220
D-7030 Böblingen (DE)**

## Gegengekoppelter Differentialverstärker

Die Erfindung betrifft einen selbsthaltenden, gegengekoppelten Differentialverstärker mit einer selbsthaltenden Rückkopplung nach dem Eingang des Verstärkers, der damit den Eingang des Verstärkers und damit die Verstärkung des Verstärkers verriegelt.

### Beschreibung des Standes der Technik

Gegengekoppelte Differentialverstärker sind allgemein bekannt. IBM Technical Disclosure Bulletin, Bd. 12, Nr. 12 vom Mai 1970 zeigt die Grundschaltung für einen gegengekoppelten Differentialverstärker. Ein derartiger Verstärker besteht im wesentlichen aus zwei als Differentialverstärker zusammengeschalteten Stromabfühlverstärkern mit parallel geschalteten Rückkopplungs-Stromkreisen, wobei die beiden Verstärker derart zusammengeschaltet sind, daß über die Abfühlleitung ankommende Stromeingangssignale verstärkt und über den Gegenkopplungstransistor dem Ausgang der Schaltung zugeführt werden. Die zwischen Ausgang und Eingang des Verstärkers liegenden Rückkopplungswiderstände sind dabei so gewählt, daß die Verstärkung im Rückkopplungsverstärker ausreicht, dann eine Detektorschaltung einzuschalten, wenn an einem der Eingänge ein Signal auftritt. Abwandlungen dieser Grundschaltung eines gegengekoppelten Differentialverstärkers sind außerdem in der US-Patentschrift 3 899 777 gezeigt. Die US-Patentschrift 3 745 539 zeigt ferner einen selbsthaltenden gegengekoppelten Verstärker.

Die US-Patentschrift 4 027 176 zeigt eine Abfühlschaltung, bei der ein Speicherausgangssignal durch einen Differentialverstärker festgestellt wird, der ausgangsseitig eine Verriegelungsschaltung mit Rückkopplung steuert.

In Abfühl-Differentialverstärkern treten im allgemeinen deswegen Fehlersignale auf, weil die miteinander gekoppelten Verstärker strukturelle Unterschiede aufweisen.

Diese strukturellen Unterschiede der Differentialverstärker haben eine Asymmetrie zur Folge, die unvermeidbar ist, so daß unabhängig von dem tatsächlich am Eingang des Leseverstärkers fließenden Strom ein differentieller Strom fließt und das Ausgangssignal eines solchen Verstärkers nicht nur eine Funktion der verstärkten Eingangssignale, sondern auch des verstärkten Fehlersignals ist. Da solche Verstärker im allgemeinen in Kaskadenschaltung eingesetzt werden, (d. h. daß der Ausgang eines ersten Verstärkers am Eingang eines zweiten Verstärkers angekoppelt ist), wird das Fehlersignal nicht nur innerhalb des Verstärkers selbst verstärkt, sondern wird auch noch in den nachfolgenden Verstärkern, die das Fehlersignal durchläuft, weiter verstärkt.

Es ist daher Aufgabe der Erfindung, einen einfachen, mit positiver Rückkopplung arbeitenden Abfühlverstärker geringen Verstärkungsgrades zur Verwendung als Impulsdiskriminator anzugeben, durch den ein bereits vorhandener Verstärker in der Weise verbessert wird, daß bereits bei einem geringen Eingangsspannungsimpuls die Verstärkung einsetzt, mit einer daran angekoppelten Verriegelungsschaltung, die das Eingangssignal des Verstärkers selbsthaltend verriegelt und verstärkt, so daß das wirksame Eingangssignal des Verstärkers um einige Größenordnungen größer wird als die ursprünglichen Eingangsspannungen.

Ein derartiger rückgekoppelter Verstärker mit parallelen Rückkopplungs-Stromkreisen, die für eine differentielle, eingangsseitige, reziproke Steilheit emittergekoppelt sind, weisen eine sehr geringe differentielle Eingangsimpedanz und eine sehr hohe Impedanz im gemeinsamen Betrieb auf.

Die der Erfindung zugrundeliegende Aufgabe wird gemäß der im Anspruch im einzelnen angegebenen Weise gelöst. Weitere Ausgestaltungen der Erfindung sind den Unteransprüchen zu entnehmen.

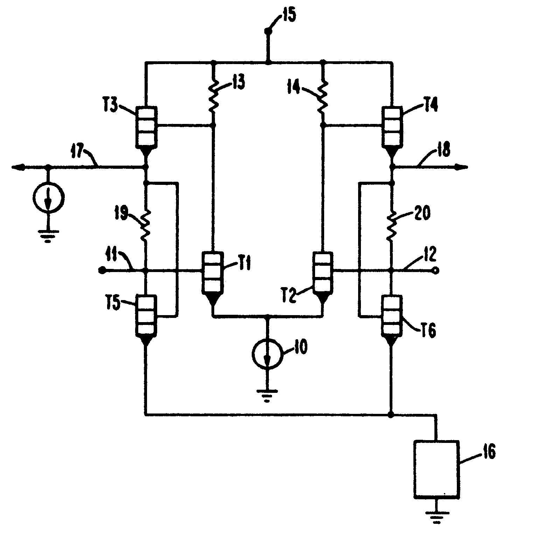

Die Erfindung wird nunmehr anhand eines Ausführungsbeispiels in Verbindung mit der beigefügten Figur beschrieben, die einen rückgekoppelten Differential-Abfühlverstärker gemäß der Erfindung zeigt.

Wie man aus der Figur erkennt, besteht der rückgekoppelte Differential-Abfühlverstärker aus zwei Stromabfühlverstärkern T1 und T3 bzw. T2 und T4, die als Differentialverstärker zusammengeschaltet sind. Die Eingangstransistoren T1 und T2 sind ein emittergekoppeltes Transistorschalterpaar mit entsprechenden Eingangsleitungen 11 und 12. Somit ist der Transistor T1 mit seiner Basis an der Eingangsleitung 11 angeschlossen, während seine Emitterelektrode an der Emitterelektrode des Transistors T2 und an einer gemeinsamen Stromquelle 10 und seine Kollektorelektrode an der Basiselektrode eines als Emitterfolger geschalteten Transistors T3 und über einen Widerstand 13 an einer positiven Spannungsquelle 15 angeschlossen sind. Der Transistor T2 ist nicht nur über Emitterkopplung am Transistor T1 und an der Stromquelle 10 angeschlossen, sondern ist an seiner Basiselektrode mit der Eingangsleitung 12 verbunden und seine Kollektorelektrode ist an der Basiselektrode eines als Emitterfolger geschalteten Transistors T4 und über einen Widerstand 14 an der positiven Spannungsquelle 15 angeschlossen.

Der als Emitterfolger geschaltete Transistor T3 ist mit seiner Kollektorelektrode an der Spannungsquelle 15 angeschlossen und seine Emitterelektrode ist mit der Ausgangsleitung 17 verbunden und über einen Widerstand 19 an die Eingangsleitung 11 angeschlossen. Die Emitterelektrode des Transistors T3 ist außerdem an der Basiselektrode einer Verriegelungstransistors T5 angeschlossen. In gleicher Weise ist der als Emitterfolger geschaltete Transistor T4 mit seiner Kollektorelektrode an der Spannungsquelle 15 angeschlossen und mit seiner Emitterelektrode an einer Ausgangsleitung 18 angekoppelt und über einen Widerstand 20 mit der Eingangsleitung 12 verbunden. Die Emitterelektrode des Transistors T4 ist außerdem an der Basis eines zweiten Verriegelungstransistors T6 angekoppelt.

Der Verriegelungstransistor T5 ist mit seiner Kollektorelektrode an der Eingangsabfühlleitung 11 angekoppelt und liegt mit seiner Emitterelektrode an einer impulsförmig betriebenen Stromquelle 16. Der Verriegelungstransistor T6 ist mit seiner Kollektorelektrode an der Eingangsleitung 12 angeschlossen und seine Emitterelektrode ist an der Emitterelektrode des Transistors T5 angekoppelt und mit der impulsmäßig betriebenen Stromquelle 16 verbunden.

Dieser Abfühlverstärker arbeitet dabei wie folgt : Auf den Eingangsleitungen 11 und 12 abgefühlte differentielle Eingangssignale werden durch die Eingangstransistoren T1 und T2 abgefühlt und über als Emitterfolger geschaltete Transistoren T3 und T4 an die Ausgangsleitungen 17 bzw. 18 abgegeben. Die Rückkopplungswiderstände 19 und 20 sind dabei so ausgewählt, daß die Verstärkung der Rückkopplungsverstärker gerade ausreicht, die Detektorschaltung durch die Spannungsdifferenz zwischen den Ausgangsleitungen 17 und 18 einzuschalten, wenn ein differentielles Signal auf den Eingangsleitungen auftritt. Es sei beispielsweise zunächst angenommen, daß das differentielle Eingangssignal sich so darstellt, daß die Eingangsleitung 11 ein niedriges Potential und die Eingangsleitung 12 ein höheres Potential aufweist. Wenn die Eingangsleitung 11 ein niedriges Potential aufweist, dann wird auch das Potential der Basiselektrode des Transistors T1 abgesenkt, so daß der Transistor T1 abzuschalten beginnt, wodurch der durch diesen Transistor T1 fließende Strom abfällt. Mit der Abnahme des durch den Transistor T1 fließenden Stromes wird die Basis des Transistors T3 positiver, so daß der Transistor T3 einschaltet und damit die Ausgangsleitung 17 und die Basiselektrode des Verriegelungstransistors T5 auf ein höheres Potential anhebt. Gleichzeitig wird die Eingangsleitung 12 auf ein höheres Potential gebracht, d. h. positiv in Bezug auf die Eingangsleitung 11, wodurch der Transistor T2 einschaltet und aus der Spannungsquelle 15 über den Widerstand 14 einen höheren Strom zieht und gleichzeitig damit die Basisspannung des als Emitterfolger geschalteten Transistors T4 absenkt. Wenn die Basisspannung des Transistors T4 abfällt, dann nimmt das Potential auf der Ausgangsleitung 18 und an der Basis des Transistors T6 ebenfalls ab.

Da die Ausgangsleitung 17 nunmehr positiver ist als die Eingangsleitung 11, tritt über dem Widerstand 19 ein Spannungsunterschied auf und es wird dann über den Transistor T5 ein Strom gezogen, wenn die Stromquelle 16 impulsmäßig angeschaltet wird, wodurch die Kollektorspannung des Transistors T5 abgesenkt und damit auch das Potential der Eingangsleitung 11 weiter in negativer Richtung abgesenkt wird. Gleichzeitig wird der Transistor T6, da der Transistor T4 abgeschaltet wird, ebenso abgeschaltet, so daß das Potential an seiner Kollektorelektrode ansteigt und positiver wird, womit die Basiselektrode des Transistors T2 und die Eingangsleitung 12 noch positiver werden. Diese Wirkung verriegelt die Eingangsleitungen 11 und 12 in dem durch die eingangsseitig abgefühlten Signale eingeleiteten Zustand. Dadurch wird eine positive Rückkopplung oder Mitkopplung erreicht. Zusätzlich bewirkt diese Rückkopplung eine Verstärkung der auf den Eingangsleitungen 11 und 12 auftretenden Eingangssignale. Wenn die Stromdifferenz der auf den Eingangsleitungen 11 und 12 liegenden Ströme 1 Mikroampere beträgt, und wenn die Stromquelle beispielsweise eine Stromsenke für 200 Mikroampere ist, dann wird, sobald die rückgekoppelte Verriegelungsschaltung über die Transistoren T5 und T6 in Betrieb kommt, offensichtlich ein differentielles Eingangssignal von 201 Mikroampere den Basiselektroden der Eingangstransistoren T1 und T2 zugeführt.

Die aus den Transistoren T1, T3 und T2, T4 bestehende Grundschaltung des rückgekoppelten Verstärkers invertiert das Eingangssignal in Bezug auf die zugehörige Ausgangsleitung, d. h. daß dann, wenn die Eingangsleitung 11 negativ ist, die Ausgangsleitung 17 ein positives Potential aufweist. Die Verriegelungstransistoren T5 und T6 müssen nicht kreuzgekoppelt sein, sondern sollen nur direkt an den entsprechenden Eingangs- und Ausgangsleitungen angekoppelt sein. Somit verriegeln die Verriegelungstransistoren T5 und T6 nicht nur das Eingangssignal, sondern verstärken es auch, so daß die Transistoren T1 und T2 noch stärker in dem Betriebszustand gehalten werden, in den sie ursprünglich durch das ankommende Eingangssignale eingestellt worden sind.

Da nur einige wenige Millivolt Spannungsdifferenz zwischen den Ausgangsleitungen 17 und 18 ausreichen, die Verriegelungstransistoren T5 und T6 in ihren Verriegelungszustand einzuschalten, braucht das Eingangssignal und die Verstärkung des Verstärkers nicht groß zu sein. Wenn die Verriegelungstransistoren T5 und T6 sich selbst halten, dann addiert sich der Strom der impulsmäßig betriebenen Stromquelle 16 zu dem Signal und liegt damit in Phase. Da die Größe des von der impulsmäßig betriebenen Stromquelle 16 gelieferten Stroms ein unabhängiger Parameter ist und in keiner Beziehung zum Verstärkungsgrad des Verstärkers oder zum Eingangssignal steht, kann dieser Strom für sich so eingestellt werden, daß das gewünschte logische Ausgangssignal eine vom Verstärkungsgrad des Verstärkers oder der Amplitude des Eingangssignals unabhängige Ausgangsamplitude aufweist. Somit liefern die Verriegelungstransistoren T5 und T6 das Ausgangspotential und nicht die Amplitude des Eingangssignals, indem dem Eingangssignal ein Pseudosignal hinzugefügt wird. Dies macht zusätzlich dazu die Verwendung eines Verstärkers mit geringerem Verstärkungsgrad möglich, der von sich aus eine größere Bandbreite und geringere Unsymmetrie aufweist.

Es sollte dem Fachmann ohne weiteres klar sein, daß die impulsmäßig betriebene Stromquelle nur dann eingesetzt wird, wenn die Eingangstransistoren T1 und T2 von sich aus nicht im Gleichgewicht sind. Sind alle Transistoren aneinander angepaßt, dann kann eine normale Stromquelle anstelle der impulsmäßig betriebenen Stromquelle 16 verwendet werden.

Die Erfindung benötigt einen Gleichstromverstärker, bei der sich die Ausgangsspannungsamplitude nur wenig von der Eingangsamplitude unterscheidet. Es können jedoch invertierende und nichtinvertierende Verstärker benutzt werden, indem man lediglich die Phasenlage an den Basiselektroden von T5, T6 durch Kreuzkopplung oder direkte Kopplung entsprechend einstellt.

## Ansprüche

1. Differentialverstärker mit einem Paar an zwei emittergekoppelten Eingangstransistoren (T1, T2) angeschlossenen Eingangsleitungen (11, 12) und einem Paar über Ausgangstransistoren (T3, T4) angekoppelter Ausgangsleitungen (17, 18) sowie mit zwei Rückkopplungswiderständen (19, 20) zwischen Ausgangsleitungen und Eingangsleitungen, dadurch gekennzeichnet, daß ein Paar emittergekoppelter Verriegelungstransistoren (T5, T6) eingangsseitig an der jeweiligen Ausgangsleitung (17, 18) und ausgangsseitig an der jeweiligen Eingangsleitung (11, 12) angeschlossen ist, und daß die miteinander gekoppelten Emitterelektroden dieser Verriegelungstransistoren (T5, T6) gemeinsam an einer Stromquelle (16) angeschlossen sind.

2. Differentialverstärker nach Anspruch 1, dadurch gekennzeichnet, daß als Stromquelle (16) eine Impuls-Stromquelle benutzt ist.

3. Differentialverstärker nach Anspruch 1, dadurch gekennzeichnet, daß er aus einem Paar emittergekoppelter Eingangstransistoren (T1, T2) besteht, die eingangsseitig mit ihrer Basiselektrode an der entsprechenden Eingangsleitung (11, 12) und ausgangsseitig mit ihrer Kollektorelektrode an der Basiselektrode des zugehörigen, als Emitterfolger geschalteten Ausgangstransistors (T3, T4) angeschlossen sind, deren Emitterelektroden mit der jeweiligen Ausgangsleitung (17, 18) gekoppelt sind.

4. Differentialverstärker nach Anspruch 3, dadurch gekennzeichnet, daß die beiden emittergekoppelten Verriegelungstransistoren (T5, T6) mit ihren Basiselektroden über einen Rückkopplungswiderstand (19, 20) mit der zugehörigen Eingangsleitung (11, 12) und unmittelbar mit der zugehörigen Ausgangsleitung (17, 18) verbunden, und mit ihren Kollektorelektroden an der jeweiligen Eingangsleitung (11, 12) angekoppelt sind.

## Claims

1. Differential amplifier with a pair of input lines (11, 12) connected to two emitter-coupled input transistors (T1, T2) and a pair of output lines (17, 18) connected via output transistors (T3, T4), as well as with two feed-back resistors (19, 20) between output lines and input lines, characterized in that a pair of emitter-coupled latch transistors (T5, T6) is connected on the input side at the respective output line (17, 18), and on the output side at the respective input line (11, 12), and that the intercoupled emitter electrodes of theses latch transistors (T5, T6) are jointly connected to a current source (16).

2. Differential amplifier as claimed in claim 1, characterized in that as a current source (16) a pulsed current source is used.

3. Differential amplifier as claimed in claim 1, characterized in that it consists of a pair of emitter-coupled input transistors (T1, T2) which on the input side are connected with their base electrode to the respective input line (11, 12) and on the output side with their collector electrode to the base electrode of the associated output transistor (T3, T4) connected as emitter follower, the emitter electrodes of said output transistors being coupled to the respective output lines (17, 18).

4. Differential amplifier as claimed in claim 3, characterized in that the two emitter coupled latched transistors (T5, T6) are connected with their base electrodes via a feed-back resistor (19, 20) to the associated input line (11, 12), and directly to the associated output line (17, 18), and coupled with their collector electrodes to the respective input line (11, 12).

## Revendications

1. Amplificateur différentiel comportant une paire de lignes d'entrée (11, 12) connectées à deux transistors d'entrée (T1, T2) ayant leurs émetteurs couplés, et une paire de lignes de sortie (17, 18) connectées à travers des transistors de sortie (T3, T4), ainsi que deux résistances à contre-réaction (19, 20) situées entre les lignes de sortie et les lignes d'entrée, caractérisé en ce qu'une paire de transistors de verrouillage (T5, T6), ayant leurs émetteurs couplés, est connectée, du côté entrée, à la ligne de sortie respective (17, 18) et est connectée, du côté sortie, à la ligne d'entrée correspondante, (11, 12) et en ce que les électrodes d'émetteur couplées de ces transistors de verrouillage (T5, T6) sont en commun connectées à une source de courant (16).

2. Amplificateur différentiel selon la revendication 1, caractérisé en ce qu'on utilise comme source de courant (16) une source de courant à impulsions.

3. Amplificateur différentiel selon la revendication 1, caractérisé en ce qu'il est composé d'une paire de transistors d'entrée (T1, T2) ayant leurs émetteurs couplés, dont l'électrode base est connectée, du côté entrée, à la ligne d'entrée correspondante (11, 12) et dont l'électrode de collecteur est connectée, du côté sortie, à l'électrode de base du transistor de sortie associé et monté en émetteur-suiveur (T3, T4), les électrodes d'émetteur desdits transistors de sortie étant connectées à la ligne de sortie correspondante (17, 18).

4. Amplificateur différentiel selon la revendication 3, caractérisé en ce que les électrodes de base des deux transistors de verrouillage (T5, T6) ayant leurs émetteurs couplés sont connectées, à travers une résistance de contre-réaction (19, 20), à la ligne d'entrée associée (11, 12), et directement à la ligne de sortie associée (17, 18), et en ce que leurs électrodes de collecteur sont connectées à la ligne d'entrée correspondante (11, 12).